# EUROPÄISCHE PATENTANMELDUNG

(11) **EP 2 151 844 A2**
(43) Veröffentlichungstag der Anmeldung: **10.02.2010**
(21) Anmeldenummer: 09008954.1
(22) Anmeldetag: 09.07.2009
(51) Int. Cl.: H01H 47/22, H05K 1/16

(54) **Elektrisches Installationsschaltgerät mit einer elektronischen Baugruppe**

(30) Priorität: 07.08.2008 DE 102008036736
(71) Anmelder: ABB AG, 68309 Mannheim (DE)
(72) Erfinder: Niewöhner, Guido, Dipl.-Ing., 69168 Wiesloch (DE)

(57) **Zusammenfassung**

Die Erfindung betrifft ein elektrisches Installationsschaltgerät, insbesondere elektromagnetisch betätigbares Schütz, mit einer Schützspule, das zum Anschluss an ein Wechselspannungsnetz eine elektronische Baugruppe, insbesondere eine Gleichrichteranordnung umfasst. Die elektronische Baugruppe ist wenigstens teilweise als mehrschichtiger Verbundkörper mit elektronischer Funktion, umfassend wenigstens ein elektronisches organisches Bauelement, ausgeführt.

## Beschreibung

Die Erfindung betrifft ein elektrisches Installationsschaltgerät, insbesondere ein elektromagnetisch betätigbares Schütz, mit einer Schützspule, das zum Anschluss an ein Wechselspannungsnetz eine elektronische Baugruppe, insbesondere eine Gleichrichteranordnung umfasst.

Ein gattungsgemäßes elektrisches Installationsschaltgerät ist beispielsweise in der DE 3743751A1 offenbart. Dort ist ein elektromagnetisch betätigbares Schütz mit einem eine Schützspule enthaltenden Gleichstromantrieb gezeigt, dem zum Anschluss an ein Wechselstromnetz eine Gleichrichteranordnung, insbesondere eine Gleichrichterdiodenanordnung, vorgeschaltet ist, um das sogenannte Brummen der Schütze zu eliminieren oder wenigstens deutlich zu eliminieren. Die DE 3743751 A1 offenbart verschiedene Schaltungen von Gleichrichteranordnungen, einfache Diodengleichrichter und Brückengleichrichter.

Es ist bekannt, dass ein Brückengleichrichter in einem elektromagnetisch betätigbaren Schütz aus diskreten elektronischen Bauelementen, also beispielsweise und insbesondere Dioden, Widerständen, Varistoren, Leiterabschnitten, aufgebaut wird. Die einzelnen Bauelemente werden einzeln miteinander verlötet, und die elektronische Baugruppe wird dann in das Schützgehäuse in der Nähe der Schützspule eingesetzt, mechanisch fixiert und elektrisch mit den Spulenanschlusswinkeln verbunden.

Es ist die Aufgabe der vorliegenden Erfindung, ein elektrisches Installationsschaltgerät zu schaffen, bei dem eine elektronische Baugruppe raumsparend und kostenreduziert in das Installationsschaltgerät eingebaut ist.

Die Aufgabe wird erfindungsgemäß gelöst durch ein elektrisches Installationsschaltgerät mit den kennzeichnenden Merkmalen des Anspruchs 1.

Erfindungsgemäß ist die elektronische Baugruppe wenigstens teilweise als mehrschichtiger Verbundkörper mit elektronischer Funktion, umfassend wenigstens ein elektronisches organisches Bauelement, ausgeführt. Der mehrschichtige Verbundkörper kann dabei eine Schichtfolge von wenigstens zwei Schichten, die homogen oder strukturiert sein können, umfassen. Weiter kann der mehrschichtige Verbundkörper wenigstens zwei hinsichtlich ihrer elektronischen Austrittsarbeit verschiedene Materialien umfassen.

Ein mehrschichtiger Verbundkörper mit elektronischer Funktion, umfassend wenigstens ein elektronisches organisches Bauelement, wird auch als gedruckte Elektronik bezeichnet. Bei der gedruckten Elektronik werden einzelne elektronische Bauelemente, aber auch integrierte Schaltungen, welche mehrere elektronische Bauelemente mit Leiterverbindungen dazwischen umfassen, schichtweise in Drucktechnik hergestellt, also als eine Art elektronische Tinte verdruckt.

Ein Feldeffekttransistor beispielsweise umfasst vier verschiedene Komponenten, nämlich eine Gateelektrode, Source- und Drainelektroden, einen Isolator und einen Halbleiter. Eine Diode umfasst drei Komponenten, nämlich eine Kathode, einen Halbleiter und eine Elektrode. Ein Kondensator umfasst drei Komponenten, nämlich zwei Elektroden und dazwischen ein Dielektrikum. Der Aufbau solcher Bauelemente oder von integrierten Schaltungen aus solchen Bauelementen in Form einer gedruckten Elektronik erfolgt durch additiven Druck verschiedener dünner Schichten auf ein Substrat.

Erfindungsgemäße mehrschichtige Verbundkörper mit elektronischer Funktion sind daher nicht zu verwechseln mit einer gedruckter Schaltung herkömmlicher Definition, bei der diskrete elektronische Bauelemente, beispielsweise Silizium-Dioden oder Transistoren, auf eine Leiterplatte aufgesetzt und dort verlötet werden.

Eine erfindungsgemäß besonders vorteilhafte Ausführungsform ist dadurch gekennzeichnet, dass die elektronische Baugruppe wenigstens teilweise in einem mehrstufigen Druckprozess in aufeinanderfolgenden Druckschritten aufgebaut ist, wobei in jedem Druckschritt eine dünne, homogene oder strukturierte, Schicht aus leitfähigem oder isolierenden oder halbleitendem Polymer oder leitfähigen Nanopartikeln oder Metall auf die darunterliegende Schicht aufgebracht ist.

Elektroden oder Leiterbahnen zum Verbinden integrierter Bauelemente eignen sich beispielsweise intrinsisch leitfähige Kunststoffe wie Polyanilin oder auch das System PE-DOT/PSS. Auch leitfähige Nanopartikel oder dünne Metallschichten, beispielsweise Silberschichten, können zum Einsatz kommen. Leitfähige Kunststoffe haben dabei bekanntermaßen eine geringe elektrische Austrittsarbeit.

Halbleiterschichten können aus konjugierten Polymeren aufgebaut werden. Dabei handelt es sich um Kunststoffe, die eine streng alternierende Sequenz von Einfach- und Doppelbindungen aufweisen und deshalb halbleitende Eigenschaften aufweisen. Zum Aufbau von Dioden in Form einer gedruckten Elektronik kann beispielsweise auch Poly(3-hexylthiophen) als Diodenmaterial zur Gleichrichtung von Wechselspannungen gut funktionierend verwendet werden. Polymere Halbleiterschichten haben eine elektrische Austrittsarbeit, die größer ist als bei leitfähigen Polymeren, aber noch kleiner ist als bei Isolatoren.

Isolatorschichten und Dielektrikumsschichten können aus isolierenden Polymeren aufgebaut werden, beispielsweise aus Polyethylenterephthalat, kurz PET.

Durch geeignetes Schaltungslayout, in etwa ähnlich zum Layout von herkömmlich bekannten integrierten Schaltungen auf Siliziumbasis, wobei selbstverständlich die Design-Regeln an die unterschiedlichen Materialeigenschaften der verschiedenen Polymerschichten anzupassen sind, und entsprechende Strukturierung der einzelnen Schichten, lassen sich mehrere Bauelemente kombinieren, so dass am Ende des Druckprozesses eine Art integrierter Polymerelektronik-Schaltkreis entsteht, eben ein mehrschichtiger Verbundkörper mit elektronischer Funktion.

Als Druckverfahren können dabei verschiedene bekannte Druckverfahren angewendet werden, beispielsweise Siebdruck, Tampondruck, Ink-Jet, Rolle-zu-Rolle etc.

Die erfindungsgemäß vorgeschlagenen Verbundkörper mit elektronischer Funktion, oder integrierte Polymerelektronik-Schaltkreise, sind dabei sehr kostengünstig und platzsparend herstellbar. Insbesondere können sie auf einer Vielzahl von Substraten aufgedruckt und damit den beengten Platzverhältnissen im Inneren eines gattungsgemäßen Installationsschaltgerätes sehr gut angepasst werden.

Eine bevorzugte Ausführungsform der Erfindung ist im Sinne einer besonders großen Platzersparnis **dadurch gekennzeichnet, dass** die elektronische Baugruppe wenigstens teilweise als gedruckte Elektronik direkt auf einem anderen elektronischen Bauteil aufgebracht ist. Beispielsweise, wenn die die elektronische Baugruppe eine Gleichrichteranordnung ist, kann sie als gedruckte Elektronik direkt auf dem Spulenkörper einer Schützspule aufgebracht, also in Drucktechnik schichtweise aufgebaut, werden. Dadurch wird besonders viel Platz gespart. Denn die gedruckte Elektronik hat nur eine sehr geringe Dicke und benötigt, auf dem Spulenkörper direkt aufgedruckt, keinen zusätzlichen Platz im Inneren des Installationsschaltgerätes.

Eine weitere, ebenfalls sehr vorteilhafte Ausführungsform der Erfindung ist im Sinne einer großen Platzersparnis **dadurch gekennzeichnet, dass** die elektronische Baugruppe wenigstens teilweise als gedruckte Elektronik auf einer Kunststofffolie als Substrat aufgebracht und mit einem anderen elektronischen Bauteil gekoppelt ist. Beispielsweise kann die elektronische Baugruppe eine Gleichrichteranordnung sein, die als gedruckte Elektronik auf einer Kunststofffolie aufgebaut ist, welche in den Spulenkörper einer Schützspule eingelegt oder um den Spulenkörper einer Schützspule herumgewickelt ist. Auch dabei benötigt die elektronische Baugruppe kaum mehr Platz im Inneren des Installationsschaltgerätes als die Schützspule selbst.

Die Erfindung betrifft auch die Verwendung eines mehrschichtigen Verbundkörpers mit elektronischer Funktion, umfassend wenigstens ein elektronisches organisches Bauelement, zum Aufbau einer elektronischen Schaltung in einem elektrischen Installationsschaltgerät, insbesondere zum Aufbau einer Gleichrichteranordnung in einem elektromagnetisch betätigbaren Schütz.

In einer besonders vorteilhaften Ausführungsform betrifft die Erfindung dabei die Verwendung eines mehrschichtigen Verbundkörpers mit elektronischer Funktion, umfassend wenigstens ein elektronisches organisches Bauelement, zum Aufbau einer Gleichrichteranordnung direkt auf dem Spulenkörper einer Schützspule eines elektromagnetisch betätigbaren Schützes.

Dabei ist insbesondere vorteilhaft die Verwendung eines mehrschichtigen Verbundkörpers mit elektronischer Funktion, umfassend wenigstens ein elektronisches organisches Bauelement, gebildet aus einer Schichtfolge von wenigstens zwei Schichten, die homogen oder strukturiert sein können, sowie aus wenigstens zwei hinsichtlich ihrer elektronischen Austrittsarbeit verschiedenen Materialien, zum Aufbau einer elektronischen Schaltung in einem elektrischen Installationsschaltgerät, insbesondere zum Aufbau einer Gleichrichteranordnung in einem elektromagnetisch betätigbaren Schütz mit wenigstens einer Schützspule, in weiter besonders vorteilhafter Weise zum Aufbau einer Gleichrichteranordnung direkt auf dem Spulenkörper einer Schützspule eines elektromagnetisch betätigbaren Schützes. Dadurch wird besonders viel Platz gespart. Denn die gedruckte Elektronik hat nur eine sehr geringe Dicke und benötigt, auf dem Spulenkörper direkt aufgedruckt, keinen zusätzlichen Platz im Inneren des Installationsschaltgerätes.

In sehr vorteilhafter Weiterbildung betrifft die Erfindung auch die Verwendung eines mehrschichtigen Verbundkörpers mit elektronischer Funktion, der wenigstens teilweise in einem mehrstufigen Druckprozess in aufeinanderfolgenden Druckschritten aufgebaut ist, wobei in jedem Druckschritt eine dünne, homogene oder strukturierte, Schicht aus leitfähigem oder isolierenden oder halbleitendem Polymer oder leitfähigen Nanopartikeln oder Metall auf die darunterliegende Schicht aufgebracht ist, zum Aufbau einer elektronischen Schaltung in einem elektrischen Installationsschaltgerät, insbesondere zum Aufbau einer Gleichrichteranordnung in einem elektromagnetisch betätigbaren Schütz mit wenigstens einer Schützspule, insbesondere zum Aufbau einer Gleichrichteranordnung direkt auf dem Spulenkörper einer Schützspule eines elektromagnetisch betätigbaren Schützes.

## Patentansprüche

1. Elektrisches Installationsschaltgerät, insbesondere elektromagnetisch betätigbares Schütz, mit einer Schützspule, das zum Anschluss an ein Wechselspannungsnetz eine elektronische Baugruppe, insbesondere eine Gleichrichteranordnung umfasst, **dadurch gekennzeichnet, dass** die elektronische Baugruppe wenigstens teilweise als mehrschichtiger Verbundkörper mit elektronischer Funktion, umfassend wenigstens ein elektronisches organisches Bauelement, ausgeführt ist.

2. Elektrisches Installationsschaltgerät nach Anspruch1, **dadurch gekennzeichnet, dass** der mehrschichtige Verbundkörper eine Schichtfolge von wenigstens zwei Schichten, die homogen oder strukturiert sein können umfasst.

3. Elektrisches Installationsschaltgerät nach Anspruch 2, **dadurch gekennzeichnet, dass** der mehrschichtige Verbundkörper wenigstens zwei hinsichtlich ihrer elektronischen Austrittsarbeit verschiedene Materialien umfasst.

4. Elektrisches Installationsschaltgerät nach Anspruch 3, **dadurch gekennzeichnet, dass** die elektronische Baugruppe wenigstens teilweise in einem mehrstufigen Druckprozess in aufeinanderfolgenden Druckschritten aufgebaut ist, wobei in jedem Druckschritt eine dünne, homogene oder strukturierte, Schicht aus leitfähigem oder isolierenden oder halbleitendem Polymer oder leitfähigen Nanopartikeln oder Metall auf die darunterliegende Schicht aufgebracht ist.

5. Elektrisches Installationsschaltgerät nach Anspruch 4, **dadurch gekennzeichnet, dass** die elektronische Baugruppe wenigstens teilweise als gedruckte Elektronik direkt auf einem anderen elektronischen Bauteil aufgebracht ist.

6. Elektrisches Installationsschaltgerät nach Anspruch 5, **dadurch gekennzeichnet, dass** die elektronische Baugruppe eine Gleichrichteranordnung ist, die als gedruckte Elektronik direkt auf einem Spulenkörper aufgebracht ist.

7. Elektrisches Installationsschaltgerät nach Anspruch 4, **dadurch gekennzeichnet, dass** die elektronische Baugruppe wenigstens teilweise als gedruckte Elektronik auf einer Kunststofffolie als Substrat aufgebracht und mit einem anderen elektronischen Bauteil gekoppelt ist.

8. Elektrisches Installationsschaltgerät nach Anspruch 7, **dadurch gekennzeichnet, dass** die elektronische Baugruppe eine Gleichrichteranordnung ist, die als gedruckte Elektronik auf einer Kunststofffolie aufgebaut ist, welche in einen Spulenkörper eingelegt oder um einen Spulenkörper herumgewickelt ist.

9. Verwendung eines mehrschichtigen Verbundkörpers mit elektronischer Funktion, umfassend wenigstens ein elektronisches organisches Bauelement, zum Aufbau einer elektronischen Schaltung in einem elektrischen Installationsschaltgerät, insbesondere zum Aufbau einer Gleichrichteranordnung in einem elektromagnetisch betätigbaren Schütz.

10. Verwendung eines mehrschichtigen Verbundkörpers nach Anspruch 9 zum Aufbau einer Gleichrichteranordnung direkt auf dem Spulenkörper einer Schützspule eines elektromagnetisch betätigbaren Schützes.

11. Verwendung eines mehrschichtigen Verbundkörpers mit elektronischer Funktion, umfassend wenigstens ein elektronisches organisches Bauelement, gebildet aus einer Schichtfolge von wenigstens zwei Schichten, die homogen oder strukturiert sein können, sowie aus wenigstens zwei hinsichtlich ihrer elektronischen Austrittsarbeit verschiedenen Materialien, zum Aufbau einer elektronischen Schaltung in einem elektrischen Installationsschaltgerät, insbesondere zum Aufbau einer Gleichrichteranordnung in einem elektromagnetisch betätigbaren Schütz mit wenigstens einer Schützspule.

12. Verwendung eines mehrschichtigen Verbundkörpers nach Anspruch 11 zum Aufbau einer Gleichrichteranordnung direkt auf dem Spulenkörper einer Schützspule eines elektromagnetisch betätigbaren Schützes

13. Verwendung eines mehrschichtigen Verbundkörpers mit elektronischer Funktion, der wenigstens teilweise in einem mehrstufigen Druckprozess in aufeinanderfolgenden Druckschritten aufgebaut ist, wobei in jedem Druckschritt eine dünne, homogene oder strukturierte, Schicht aus leitfähigem oder isolierenden oder halbleitendem Polymer oder leitfähigen Nanopartikeln oder Metall auf die darunterliegende Schicht aufgebracht ist, zum Aufbau einer elektronischen Schaltung in einem elektrischen Installationsschaltgerät, insbesondere zum Aufbau einer Gleichrichteranordnung in einem elektromagnetisch betätigbaren Schütz mit wenigstens einer Schützspule.

14. Verwendung eines mehrschichtigen Verbundkörpers nach Anspruch 13 zum Aufbau einer Gleichrichteranordnung direkt auf dem Spulenkörper einer Schützspule eines elektromagnetisch betätigbaren Schützes.
